# EUROPEAN PATENT SPECIFICATION

(11) **EP 1 079 423 B1**
(45) Date of publication and mention of the grant of the patent: **03.01.2007**
(21) Application number: 99913610.4
(22) Date of filing: 09.04.1999
(51) Int. Cl.: H01L 21/00, H01J 37/32, C23C 16/24

(54) **APPARATUS FOR GAS PROCESSING**
VORRICHTUNG ZUR GASBEHANDLUNG
APPAREIL DE TRAITEMENT AU GAZ

(30) Priority: 09.04.1998 JP 11420498
(43) Date of publication of application: 28.02.2001
(73) Proprietor: TOKYO ELECTRON LIMITED, Tokyo 107-8481 (JP)
(72) Inventor: AMANO, Hideaki, Zama-shi, Kanagawa 228-0002 (JP)
(74) Representative: Liesegang, Eva
(86) International application number: PCT/JP1999/001902
(87) International publication number: WO 1999/053533

(56) References cited:
- EP-A- 0 403 418
- EP-A- 0 413 239
- JP-A- 4 211 118
- US-A- 5 234 526
- US-A- 5 552 017
- PATENT ABSTRACTS OF JAPAN vol. 017, no. 394 (C-1088), 23 July 1993 (1993-07-23) -& JP 05 070956 A (KOBE STEEL LTD), 23 March 1993 (1993-03-23)
- PATENT ABSTRACTS OF JAPAN vol. 018, no. 556 (E-1620), 24 October 1994 (1994-10-24) -& JP 06 204181 A (IBIDEN CO LTD), 22 July 1994 (1994-07-22)
- PATENT ABSTRACTS OF JAPAN vol. 006, no. 218 (E-139), 2 November 1982 (1982-11-02) & JP 57 121236 A (MATSUSHITA DENSHI KOGYO KK), 28 July 1982 (1982-07-28)
- PATENT ABSTRACTS OF JAPAN vol. 014, no. 479 (E-0992), 18 October 1990 (1990-10-18) -& JP 02 198138 A (NEC CORP), 6 August 1990 (1990-08-06)
- PATENT ABSTRACTS OF JAPAN vol. 015, no. 263 (C-0847), 4 July 1991 (1991-07-04) -& JP 03 090577 A (HITACHI LTD; others: 01), 16 April 1991 (1991-04-16)

## Description

### BACKGROUND OF THE INVENTION

### Field of the Invention

The present invention relates to a gas processing unit according to the preamble of claim 1. A gas processing unit of this type is known from JP-A 05 070956.

Another type of gas processing unit is known US-A-5, 234, 526. This processing unit includes a microwave transmitting window having a microwave lead-in opening. Microwave-penetrable substances are located inside the microwave lead-in opening and the gas intended for plasma generation is removed from the area which, in combination with the optimum distribution of the electric field strength, the homogeneity of the microwave-propagating material and the increase of the impedance matching makes it possible to produce a uniform plasma distribution.

### Disclosure of the prior art

Recently, as one method for conducting a film-forming process or an etching process by using a plasma, attention is focused on an ECR (Electron Cyclotron Resonance) plasma processing method, which generates a microwave discharge by utilizing a resonance phenomenon between an electron cyclotron movement and a microwave in a magnetic field. According to the method, a plasma having a higher density can be generated in a higher vacuum by electrodeless discharge. Thus, a surface processing can be achieved at a higher speed. In addition, there is less fear that a semiconductor wafer or the like may be contaminated or polluted.

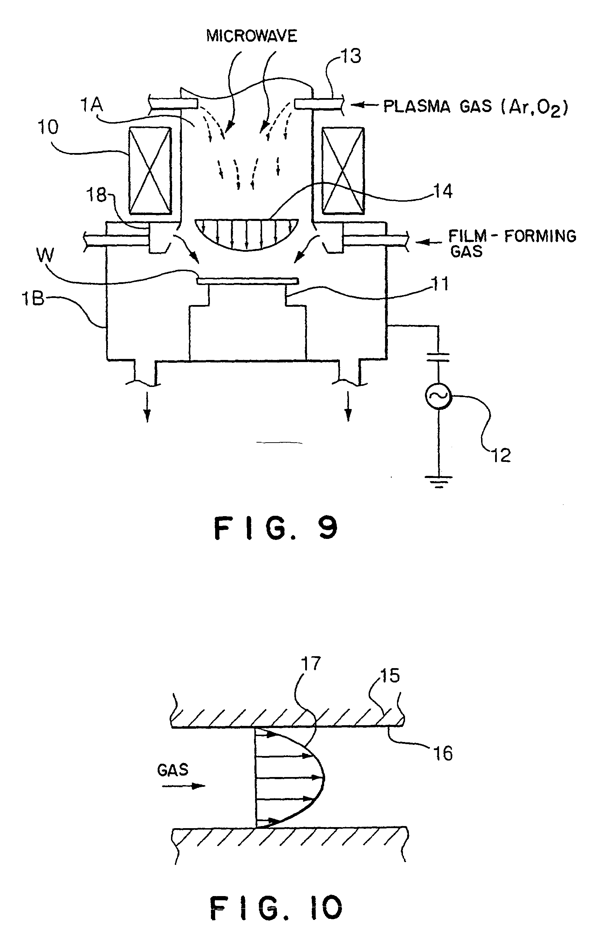

An example of a conventional plasma processing unit for conducting such an ECR plasma process is explained with reference to Fig.9, about a case of a film-forming process. A microwave of for example 2.45 GHz is supplied into a plasma generating chamber 1A through a wave guide not shown. At the same time, an electromagnetic coil 10 generates a magnetic field of a predetermined strength such as 875 gauss. Then, by an interaction (a resonance) of the microwave and the magnetic field, a plasma-generating gas such as Ar gas, which can be supplied from an upper portion of the plasma generating chamber 1A, can be changed into a plasma with a higher density. A reactive film-forming gas, which can be introduced from a side portion of a film-forming chamber 1B through gas holes of a circular gas-supplying member 18, can be activated by the plasma in the film-forming chamber 1B to make an activating seed. Thus, a spatter-etching process and an accumulating process can be conducted to a surface of a silicon wafer W placed on a stage 11 connected to a high-frequency power source 12 at the same time. The spatter-etching process and the accumulating process are counter to each other. In the case, they are controlled in such a manner that the accumulating process is superior to the spatter-etching process in a macroscopic view. That is, as a whole, the accumulating process is conducted.

Recently, semiconductor devices are required to be minute and to operate at a higher speed. In such a situation, attention is being focused on a CF film as an effective insulation film having a small dielectric constant. In a case of accumulating a CF film on a surface of a wafer, a CF gas (a carbon fluoride gas) such as C₄F₈ gas is used as a reactive gas. However, when the CF film is accumulated on the surface of the wafer by using the conventional processing unit shown in Fig.9, a peripheral area of the accumulated CF film has a greater thickness, and a central area thereof has a smaller thickness. The problem is more remarkable when the wafer has a larger size.

The reason of such uneven distribution of the film thickness has not been solved clearly. However, inventors of this invention guess the reason as follows.

As shown in Fig.9, the plasma-generating gas is supplied from gas nozzles 13, whose number may be 8 to 16, arranged at an upper side portion of the tubular plasma generating chamber 1A toward a central area thereof in a radial direction thereof. Then, the plasma-generating gas flows downward in the plasma-generating chamber 1A to an ECR point near to a border between the plasma generating chamber 1A and the film forming chamber 1B.

In general, as shown in Fig.10, a gas flow in a pipe 15 has a greatest velocity at a central area of the pipe 15. On the contrary, the gas flow has a smaller velocity at an area nearer to an inside surface 16 of the pipe 15. In Fig.10, respective velocities of the gas flow at respective areas are represented by vector arrows 17. A vector arrow in a central area of the pipe is longest. A vector arrow in an area nearer to a side end is shorter.

As described about Fig.10, it can be thought that the gas flow flowing downward in the pipe has a larger velocity at a central area of the plasma generating chamber 1A, and a smaller velocity at an area nearer to the inside surface. Thus, it can be thought that the gas flow at the ECR point has a greatest velocity at a central area as shown by the vector arrows 14 in Fig.9. A difference of the velocities between the central area and the peripheral area at the ECR point may be larger when the wafer has a larger size.

Ar ions generated in the plasma process are charged particles. Thus, they are supplied onto the wafer W while bound by the magnetic field. At that time, the supply of the Ar ions onto the wafer W depends on the velocity distribution of the gas flow at the ECR point. That is, a volume of the supplied Ar ions (charged particles) per unit time and unit area is larger at a central area of the wafer. Thus, in the area, the CF gas may be easily decomposed to generate F (fluorine). The generated F operates to etch the CF film accumulated on the surface of the wafer. Thus, the etching effect is greater in the central area of the wafer than in the peripheral area thereof. That is, the CF film is thinner in the central area of the wafer.

This invention is intended to solve the above problem effectively. The object of this invention is to provide a gas processing unit, which can conduct a uniform process to a surface of a substrate such as a wafer by using a process gas.

### SUMMARY OF THE INVENTION

The present invention provides a gas processing unit according to claim 1.

For example, an opening size of each of the gas holes in the area for the peripheral area of the substrate may be larger than an opening size of each of the gas holes in the area for the central area of the substrate. Alternatively, a number of the gas holes may be larger in the area for the peripheral area of the substrate than in the area for the central area of the substrate.

Preferably, the gas-holes obstructing member is adapted to obstruct the gas holes of the gas-supplying member in the area mainly for the peripheral area of the substrate. In addition, preferably, the gas-holes obstructing member is exchangeable. For example, the gas-holes obstructing member may have a plurality of blade-like members overlapping in an adjustable manner.

In addition, a gas processing unit according to the invention further includes: a microwave penetrable window hermetically arranged in an opening formed in the vacuum container, the window facing the substrate placed on the stage; a wave guide connected to the vacuum container via the microwave penetrable window for introducing a microwave into the vacuum container; and a magnetic-field forming means for generating a magnetic field in the vacuum container; wherein the gas processing unit is adapted to generate an electron cyclotron resonance in the vacuum container by an interaction of the microwave introduced through the wave guide and the magnetic field, to change the process gas into a plasma and to process the substrate by the plasma.

In the case, the gas-supplying member may be made of a microwave penetrable material. In addition, the gas processing unit may further include said gas-holes obstructing member made of an electric conductor for obstructing the gas holes.

The gas holes may be arranged in a space between the microwave penetrable window and the substrate placed on the stage and in a plane parallel to the substrate. Alternatively, the gas holes may be arranged in a substantially peripheral area of a space between the microwave penetrable window and the substrate placed on the stage and in a plane parallel to the substrate.

### BRIEF DESCRIPTION OF THE DRAWINGS

Fig.1 is a schematic view of an example of a gas processing unit used for an embodiment according to the invention;
Fig.2 is a plan view of a gas-supplying member in the gas processing unit shown in Fig.1;
Fig.3 is a plan view of a situation wherein a part of gas holes of the gas-supplying member shown in Fig.1 is obstructed by a gas-holes obstructing member;
Fig.4 is an explanatory view for explaining a state of a gas flow at an ECR point of a gas processing unit using a gas-supplying member in which an opening area of gas holes per unit area is uniform;
Fig. 5 are explanatory views for explaining operations of the gas-holes obstructing member;
Fig.6 is a schematic view of another example of a gas processing unit;
Fig.7 is a plan view of a gas-supplying member in the gas processing unit shown in Fig.6;
Fig.8 is a schematic view of a main part of the gas processing unit shown in Fig.6 provided with a gas-holes obstructing member used for an embodiment according to the invention;
Fig.9 is a schematic view of a film-forming unit using conventional plasma; and
Fig.10 is an explanatory view for explaining a state of a gas flow flowing in a pipe.

### DESCRIPTION OF THE PREFERRED EMBODIMENT

Embodiments of the invention will now be described with reference to drawings.

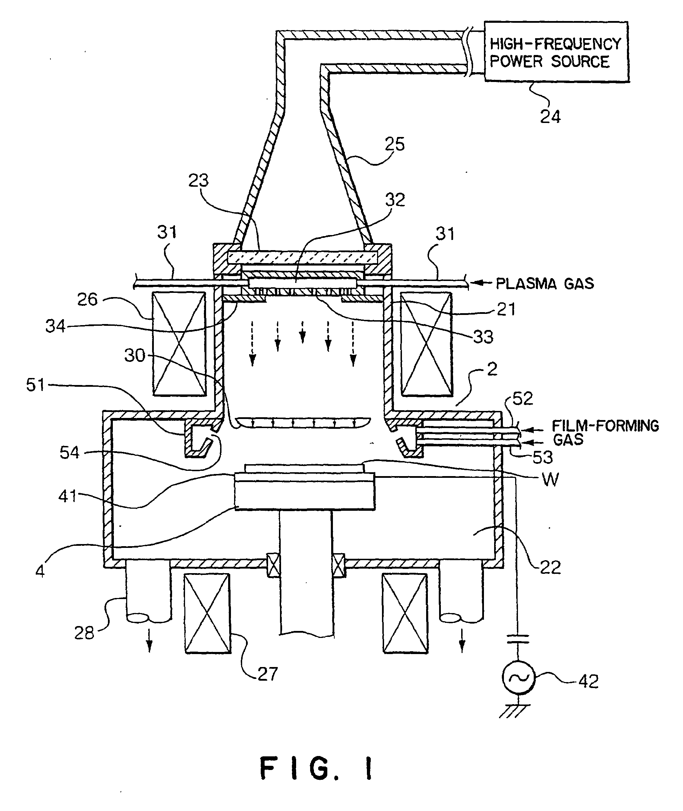

At first, an example of a gas processing unit used for an embodiment according to the invention is shown in Fig.1. The unit includes a vacuum container 2 made of for example aluminum or the like. The vacuum container 2 consists of a first cylindrical vacuum chamber 21 located in an upper portion thereof for generating plasma; and a second cylindrical vacuum chamber 22 located under and connected to the first vacuum chamber 21, having a diameter larger than that of the first vacuum chamber 21. In addition, the vacuum container 2 is grounded to be in zero potential.

An upper end of the vacuum container 2 has an opening. A penetrable window 23 made of a microwave penetrable material such as a crystal is sealingly fitted in the opening. Thus, an inside of the vacuum container 2 can be maintained at a vacuum. A wave guide 25 is provided outside of the penetrable window 23. The wave guide 25 is connected to a high-frequency power source 24, which can generate a microwaver of for example 2.45 GHz. Then, the microwave generated by the high-frequency power source 24 is introduced into the wave guide 25 by for example a TE mode. Alternatively, the microwave guided by the TE mode is converted to a TM mode in the wave guide 25. Then, the microwave can be introduced into the first vacuum chamber 21 through the penetrable window 23.

A showerhead 32 as a gas-supplying member for supplying a plasma-generating gas (for example Ar gas) into the first vacuum chamber 21 is arranged for example near to an upper end of the first vacuum chamber 21, that is, just below the penetrable window 23. The showerhead 32 is adapted to face a wafer W as a substrate to be processed placed on a stage 4 described below. The showerhead 32 is connected to gas nozzles 31 piercing through a side wall defining the first vacuum chamber 21. The other ends of the gas nozzles 31 are connected to a gas source such as an Ar gas source not shown.

The showerhead 32 is a disk-like hollow box made of a crystal. A plurality of through gas holes 33 are formed in a base plate thereof. A circular gas-holes obstructing member 34 for controlling to open and close the gas holes 33 is arranged below the showerhead 32. The invention has a feature in distribution of opening area of the gas holes of the showerhead 32. The feature is described in detail as below.

The stage 4 for the wafer is arranged in the second vacuum chamber 22 to face the first vacuum chamber 21. The stage 4 has an electrostatic chuck 41 in a surface portion thereof. Electrodes of the electrostatic chuck 41 are connected to a direct-current power source (not shown) to stick to the wafer and to a high-frequency power source 42 for applying a bias voltage to draw ions up to the wafer.

A circular film-forming-gas supplying member 51 is provided at an upper portion of the second vacuum chamber 22, that is, at a connecting portion of the second vacuum chamber 22 and the first vacuum chamber 21. The film-forming-gas supplying member 51 include for example gas supplying pipes 52, 53 and gas holes 54 formed in an inside surface thereof. For example, two kinds of film-forming gases are supplied through the respective gas supplying pipes 52, 53. Then, a mixed gas from the two kinds of film-forming gases is supplied into the vacuum container 2 via the gas holes 54.

A magnetic-field forming means such as a circular main electromagnetic coil 26 is arranged around and near to the side wall defining the first vacuum chamber 21. A circular assistant electromagnetic coil 27 is arranged below the second vacuum chamber 22. Exhausting pipes 28 are connected to a base plate of the second vacuum chamber 22 for example at two positions symmetric with respect to a central axis of the vacuum chamber 22.

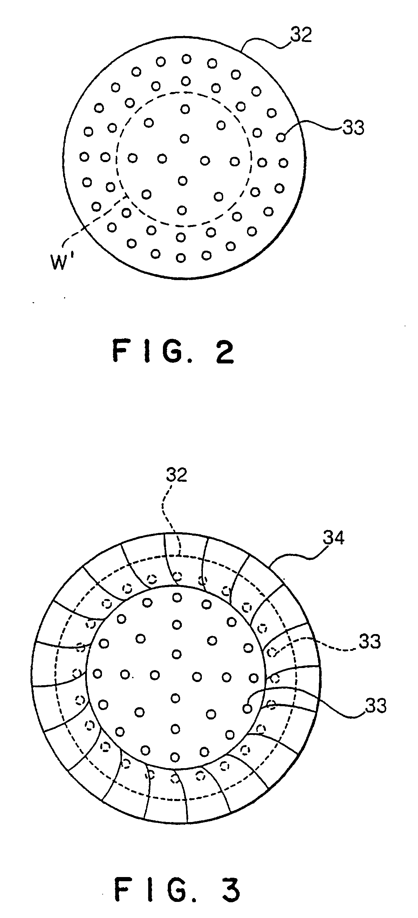

Fig.2 shows the base plate of the showerhead 32. In the showerhead 32, an open area of the gas holes 33 per unit area is larger in a peripheral area of the head than in a central area thereof. In detail, as shown in Fig.2, the gas holes 33 having the same open size are arranged more densely in a more peripheral area. A relationship between a distance from a central axis of the showerhead 32 and an open area of the gas holes 33 per unit area is such a relationship that, as shown by vector arrows (that represent velocities of a gas flow) with a numeral sign 30 in Fig.1, velocities of a gas flow of the plasma-generating gas at an ECR point are uniform with respect to the wafer. In general, an area where the gas holes are arranged densely is located outside of a projection W' (shown by a dotted line in Fig.2) of the wafer W. However, the area may partly overlap with the projection W' of the wafer W. In the case, a diameter of each of the gas holes 33 is 0.2 to 0.5 mm, because an abnormal discharge may tend to be easily generated if the diameter is over the range. In addition, a distance from the showerhead 32 to the ECR point is 220 mm.

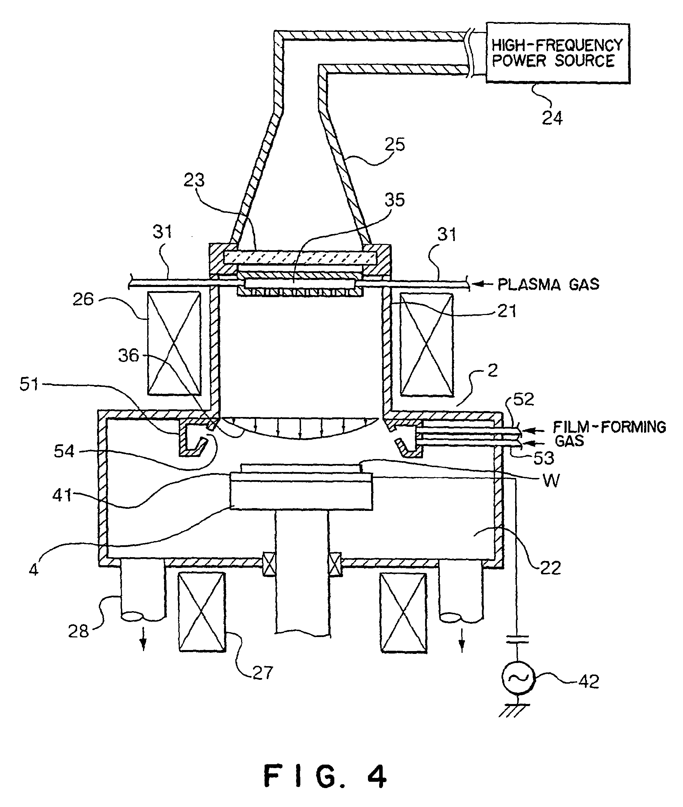

If using a showerhead wherein an open area of the gas holes 33 per unit area is uniform, as shown by vector arrows 36 in Fig.4, it may be thought that the plasma-generating gas at the ECR point has a greatest velocity in a central area thereof. Thus, spatter-etching operation in the central area of the wafer becomes so strong that an accumulated film has an uneven thickness. The example prevents the velocity of the plasma-generating gas from becoming not uniform.

Alternatively, as another example, diameters of the gas holes 33 may gradually increase in the range of 0.2 to 0.5 mm from the central area of the showerhead 32 to the peripheral area thereof. In the case, the number of the gas holes 33 per unit area may be the same everywhere in the showerhead 32 or may increase from the central area of the showerhead 32 to the peripheral area thereof.

Fig.3 shows a situation wherein a part of gas holes 33 of the showerhead 32 is obstructed by the gas-holes obstructing member 34. The gas-holes obstructing member 34 consists of a plurality of blade-like members, each adjacent two of which overlap with each other a little, just like a diaphragm mechanism in a camera. By adjusting the overlapping condition, a size of an opening defined by the plurality of blade-like members can be changed. Thus, in the example shown in Fig.3, although the gas-holes obstructing member 34 obstructs gas holes arranged on a most outside circumference, the gas-holes obstructing member 34 may obstruct no gas holes by enlarging the opening thereof or may obstruct gas holes arranged on a second or third outside circumference as well by narrowing the opening thereof.

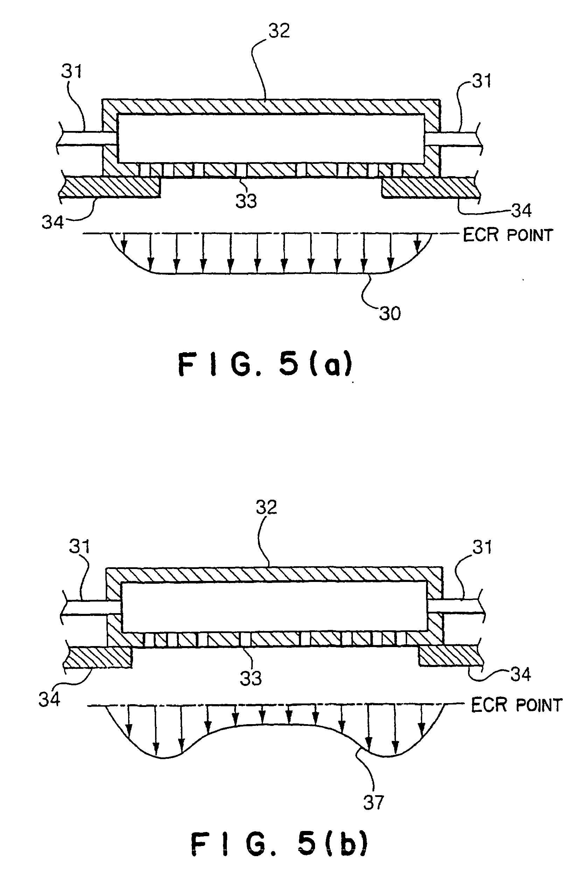

As described above, by controlling a pattern defined by the gas holes 33, an effective area for blowing the plasma-generating gas may be adjusted. In general, when a kind of the plasma-generating gas is changed, a distribution of plasma density may be changed at the ECR point. In addition, it may be necessary to change a distribution of the gas flow velocity of the plasma-generating gas, based on characteristics of a formed film. In the case, the distribution of the gas flow velocity may be revised by not changing the showerhead 32 but adjusting the pattern of the gas holes by means of the gas-holes obstructing member 34. Thus, a planned distribution of plasma density may be obtained at the ECR point. In detail, when the gas holes 33 near to the outside periphery of the showerhead 32 are not obstructed, as shown by vector arrows 37 in Fig.5(b), the gas flow of the plasma-generating gas at the ECR point may have a too great velocity at an area near to the periphery rather than at a central area. Then, a thickness of a film accumulated on the wafer W may be uneven. In the case, if the gas holes 33 near to the outside periphery of the showerhead 32 are suitably obstructed by the gas-holes obstructing member 34, as shown in Fig.5(a), a gas flow having an uniform velocity at the ECR point may be obtained.

In addition, when the gas-holes obstructing member 34 is made of an electric conductor such as a metal, the gas-holes obstructing member 34 may also have a function to adjust a penetrable area of the microwave that has penetrated through the penetrable window 23.

Alternatively, in another example, the gas-holes obstructing member 34 may be arranged in such a manner the size of the opening thereof may not be adjusted freely. In the case, the gas-holes obstructing member 34 can be attached to and removed from the first vacuum chamber 21. In addition, a plurality of gas-holes obstructing members 34 whose opening sizes are different from each other may be prepared. Then, one gas-holes obstructing member may be suitably chosen from the plurality of gas-holes obstructing members and attached to the first vacuum chamber 21.

Then, a method for forming a interlayer dielectric film consisting of a CF film onto a wafer W as a substrate to be processed by using the unit described above is explained. At first, a gate valve (not shown) provided at the side wall of the vacuum container 2 is opened. A conveying arm (not shown) conveys a wafer W, which has for example an aluminum circuit on an upper surface thereof, from the load-lock chamber (not shown) onto the stage 4. The wafer 4 conveyed onto the stage 4 is electrostaticly stuck to the electrostatic chuck 41.

Then, the gate valve is closed, that is, the inside of the vacuum container 2 is hermetically closed. Then, gas in the inside of the vacuum container 2 is exhausted from the exhausting pipes 28, and the inside of the vacuum container 2 is produced to a predetermined vacuum. After that, a plasma-generating gas such as Ar gas is introduced into the first vacuum chamber 21 through the plasma-gas nozzle 31 and a CF film-forming gas is introduced from the film-forming gas supplying member 51 into the second vacuum chamber 22 at a predetermined flow rate. The pattern of the gas holes, which is determined by a distribution of the gas holes 33 in the showerhead 32 and an arrangement of the gas-holes obstructing member 34, is adjusted most suitably in advance, based on preparatory experiments and/or process data in the past and so on.

Then, the inside of the vacuum container 2 is maintained at a predetermined process pressure. The high-frequency power source 42 applies a bias voltage of 13.56 MHz and 1500 W to the stage 4. In addition, a temperature of the upper surface of the stage 4 is set to about 400 °C.

The high-frequency wave (microwave) of 2.45 GHz from the high-frequency power source 24 is introduced into the first vacuum chamber 21 through the wave guide 25 and through the penetrable window 23 at a ceiling of the vacuum container 2. In the container 2, the electromagnetic coils 26 and 27 form a magnetic field in a direction from an upper portion of the first vacuum chamber 21 toward a lower portion of the second vacuum chamber 22. For example, a strength of the magnetic field at a lower portion of the first vacuum chamber 21 is 875 gauss. Then, an electric cyclotron resonance is generated by an interaction between the magnetic field and the microwave. The resonance causes the Ar gas to become plasma and to be much dense. A plasma flow flowing from the first vacuum chamber 21 into the second vacuum chamber 22 activates the CF gas supplied thereinto to make activated seeds and to form a CF film on the wafer W.

In a case of manufacturing actual devices, after that, the CF film may be etched with a predetermined pattern by means of a predetermined etching means such as O₂ (plasma). For example, W films may be buried in etched grooves to form a W circuit.

According to the above embodiment, since the showerhead 32 is arranged in such a manner that the open area of the gas holes 33 per unit area is larger in the peripheral area of the head than in the central area thereof, it may be prevented that the gas flow of the plasma-generating gas become slow at an area near to the inside surface of the first vacuum chamber 21. Thus, the flow velocity of the plasma-generating gas at the ECR point can be uniform with respect to the wafer W. Thus, a gas flow rate per unit time and per unit area can be uniform above the wafer W, spatter-etching effect on the surface of the wafer W can be uniform, and the thickness of the film accumulated on the wafer W can be uniform in a radial direction of the wafer W.

In addition, according to the above embodiment, even when a material of an accumulated film or a kind of the plasma-generating gas is changed, a gas flow having a uniform flow velocity can be obtained by adjusting the pattern of the gas holes by means of the gas-holes obstructing member 34. Thus, there is no need to prepare a plurality of showerhead which have various patterns of the gas holes. Thus, films of various materials can be accumulated by using various kinds of plasma-generating gas at small cost.

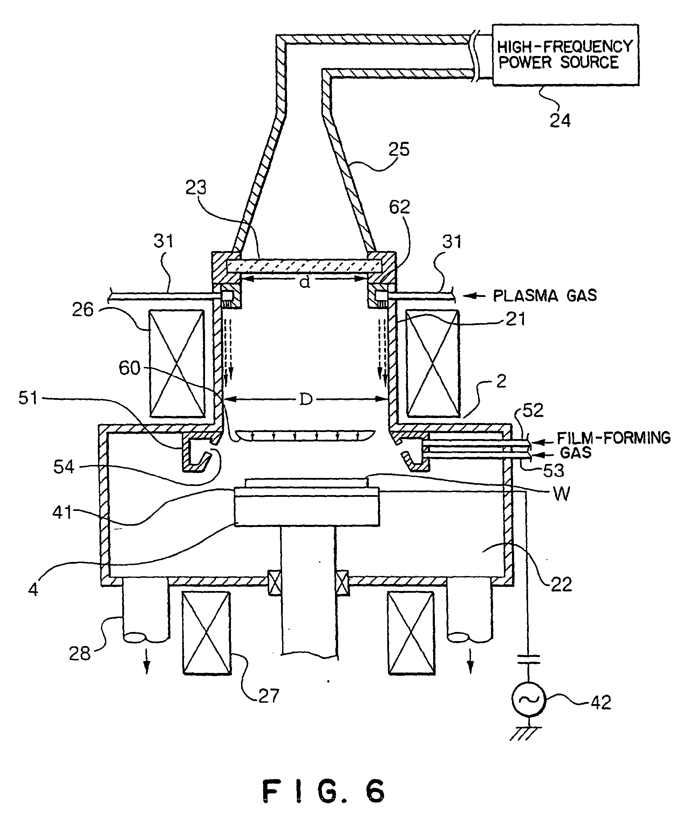

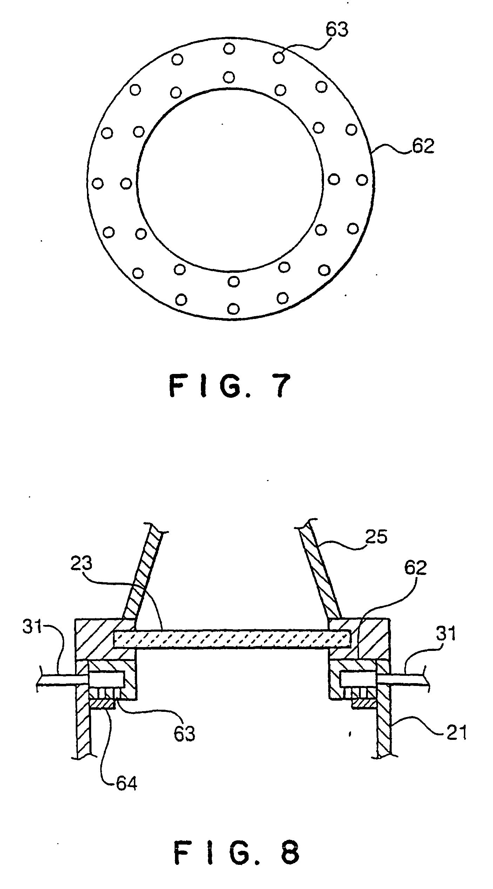

Another example of an embodiment according to the invention is shown in Fig 8. In Fig 6, the plasma processing unit is different from the unit shown in Figs.1 to 3, in that a gas-ring 62 is provided as a ring-like gas supplying member instead of the showerhead 32 and that the gas-holes obstructing member 34 is omitted. Other structure is the same as the example shown in Figs.1 to 3 and described above. Thus, the same numeral references correspond to the same elements as the example shown in Figs.1 to 3. The detailed explanation of the same elements is not repeated.

As shown in Fig.7, the gas-ring 62 consists of a hollow ring-like box surrounding an effective area of the penetrable window 23 (an area designated by a diameter d in Fig.6). A plurality of gas holes 63 are formed in a base plate of the gas-ring 62. The plurality of gas holes 63 are arranged just below the penetrable window 23 to face a plane including an upper surface of the wafer W. The gas-ring 62 is connected to a gas source of Ar gas or the like through the gas nozzles 31. The gas-ring 62 is made of a metal or an insulation such as a crystal. A dimension of the diameter d may be about 190 mm, for example if an inside diameter D of the first vacuum chamber 21 is 250 mm. That is, in the case, the inside diameter and the outside diameter of the gas-ring 62 are about 190 mm and about 250 mm, respectively.

The gas holes 63 may be arranged in such a manner that an open area of the gas holes 63 per unit area is larger in a peripheral area, that is, in an outside area than in a central area, that is, an inside area. Alternatively, the gas holes 63 may be arranged in such a manner that an open area of the gas holes 63 per unit area is the same everywhere in the gas-ring 62.

By supplying the plasma-generating gas into the first vacuum chamber 21 by means of the gas-ring 62, the plasma-generating gas flows downward from a peripheral area of the first vacuum chamber 21. Thus, a gas density at a central area near to the gas-ring 62 is small. Combination of this fact and the fact that a gas flow tends to have a larger velocity in a central area than in a peripheral area at the ECR point causes the flow velocity of the plasma-generating gas at the ECR point to be uniform with respect to the wafer W, as shown by vector arrows 60 (which represent velocities of the gas flow) in Fig.6.

As shown in Fig.8, a ring-like gas-holes obstructing member 64 may be arranged below the gas-ring 62 in order to control to open and close the gas holes 63. The gas-holes obstructing member 64 is the same as the gas-hole obstructing member 34 described above. Thus, a pattern of the gas holes 63 can be adjusted, based on a material of an accumulated film or a kind of the plasma-generating gas. Then, a distribution of the gas flow velocity may be revised, and a planned distribution of plasma density may be obtained at the ECR point.

According to the embodiment shown in Fig 8, a gas flow rate per unit time and per unit area can be uniform above the wafer W, spatter-etching effect on the surface of the wafer W can be uniform, and the thickness of the film accumulated on the wafer W can be uniform in a radial direction of the wafer W. In addition, since the gas-ring 62 is arranged outside the penetrable window 23, the microwave may not pass through the gas supplying member. Thus, it may be prevented that a film is formed in the gas supplying member.

In the above embodiments, the exhausting pipes may be connected to a bottom portion of the side wall of the vacuum container, and the electromagnetic coil for forming the magnetic field may be provided in a side area of the wave guide. In addition, this invention may be applied to not only the unit for conducting a film-forming process but also various units for processing a substrate with plasma such as an etcher for etching a substrate with plasma made of CF gas. In addition, this invention may be applied to not only the case of processing a substrate with plasma but also a case of decomposing a process gas with heat to form activated seeds and to form films by using the activated seeds.

In addition, this invention is not limited to the manner of generating plasma by ECR. For example, this invention may be applied to a case of generating plasma by a method called ICP (Inductive Coupled Plasma) wherein a coil wound around a dome-like container gives an electric field and a magnetic field to a process gas. This invention may also be applied to a case of generating plasma by an interaction of a helicon wave of for example 13.56 MHz and a magnetic field by formed by a magnetic coil, which plasma is called helicon-wave plasma. This invention may also be applied to a case of generating plasma by applying a magnetic field to two parallel cathodes in a substantially parallel manner, which plasma is called magnetron plasma. This invention may also be applied to a case of generating plasma by applying a high-frequency electric power between electrodes facing with each other, which are called parallel-plates.

In this invention, a substrate is not limited to the wafer, but may be a glass substrate for a liquid crystal display.

As described above, according to a feature of the invention, the process gas is supplied more in the outside area than in the central area from the gas supplying member which is arranged at a position to face the substrate or a plane extended from the substrate. Thus, a surface of the substrate can undergo a uniform process.

## Claims

1. A gas processing unit comprising;
a stage (4) on which a substrate (w) can be placed,
a vacuum container (2) surrounding the stage, inside of which can be produced a vacuum,
a plasma-generating-gas supplier (32) having a plurality of gas holes (33, 63), which can introduce a gas for generating a plasma in the vacuum container, and
a process-gas supplier (52, 53) that can introduce a process gas for conducting a predetermined plasma process to the substrate in the vacuum container,
wherein an opening density of the gas holes (33, 63) of the plasma-generating-gas supplier (32, 62) is greater in an area for a peripheral area of the substrate than in an area for a central area of the substrate, and the plasma-generating-gas supplier (32, 62) and the process-gas supplier (52, 53) are separately arranged; **characterized by** a gas-holes obstructing member (34, 64) for obstructing the gas holes (33, 63) of the plasma-generating-gas supplier (32, 62), the gas-holes obstructing member (34, 64) being adjustable to change the gas holes obstructed thereby.

2. A gas processing unit according to claim 1, wherein:
an opening size of each of the gas holes (33) of the plasma-generating-gas supplier (32) in the area for the peripheral area of the substrate is larger than an opening size (33) of each of the gas holes of the plasma-generating-gas supplier (32) in the area for the central area of the substrate.

3. A gas processing unit according to claim 1 or 2, wherein:
a number of the gas holes (33) of the plasma-generating-gas supplier (32) is larger in the area for the peripheral area of the substrate than in the area for the central area of the substrate.

4. A gas processing unit according to one of the preceding claims, wherein:
the gas-holes obstructing member (34) is adapted to obstruct the gas holes (33) of the gas-supplying member in the area for the peripheral area of the substrate.

5. A gas processing unit according to one of the preceding claims, wherein:
the gas-holes obstructing member (34) is exchangeable.

6. A gas processing unit according to one of the preceding claims, wherein:
the gas-holes obstructing member (34) has a plurality of blade-like members overlapping in an adjustable manner.

7. A gas processing unit according to claim 1, further comprising:
a microwave penetrable window (23) hermetically arranged in an opening formed in the vacuum container (2), the window (23) facing the substrate,
a wave guide (25) connected to the vacuum container (2) via the microwave penetrable window (23) for introducing a microwave into the vacuum container (2), and
a magnetic-field forming means for generating a magnetic field in the vacuum container (2),
wherein the gas processing unit is adapted to generate an electron cyclotron resonance between the plasma-generating-gas supplier (32) and the process-gas supplier (52, 53) in the vacuum container (2) by an interaction of the microwave introduced through the wave guide (25) and the magnetic field, to change the process gas into a plasma and to process the substrate by the plasma.

8. A gas processing unit according to claim 7, wherein:
the plasma-generating-gas supplier (32) is made of a microwave penetrable material.

9. A gas processing unit according to claim 7 or 8, wherein the:
gas-holes obstructing member (34) is made of an electric conductor.

10. A gas processing unit according to one of claims 7 to 9, wherein:
the gas holes (33) of the plasma-generating-gas supplier (32) are arranged in a space between the microwave penetrable window (23) and the substrate placed on the stage (4) and in a plane parallel to the substrate.

11. A gas processing unit according to one of claims 7 to 10, wherein:
the plasma-generating-gas supplier is formed by a ring-like hollow box (62) arranged in a substantially peripheral area of a space between the microwave penetrable window (25) and the substrate placed on the stage, and has the plurality of gas holes (63) facing the substrate in a base portion thereof.

12. A gas processing unit according to one of the preceding claims, wherein:
the stage (4) is adapted to support a substantially circular substrate,
the gas holes (33) are arranged in a plane parallel to the substrate, and
the vacuum container (2) has a substantially cylindrical shape at least at a portion provided with the gas holes (33).

13. A gas processing unit according to one of the preceding claims, further comprising:
an etching processing mechanism.

14. A gas processing unit according to one of the preceding claims, further comprising:
a film-forming processing mechanism.

15. A gas processing unit according to one of the preceding claims, wherein:
the plasma-generating-gas supplier is formed by a ring-like hollow box (62), and has the plurality of gas holes (63) facing the substrate in a base portion thereof.

## Patentansprüche

1. Gasverarbeitungseinheit, die folgendes umfaßt:
eine Station (4), auf der ein Substrat (w) plaziert werden kann,
einen Vakuumbehälter (2), der die Station umgibt und innerhalb dessen ein Vakuum hergestellt werden kann,
eine Plasmaerzeugungsgas-Zufuhrvorrichtung (32), die eine Mehrzahl von Gasöffnungen (33, 63) aufweist und die ein Gas zum Erzeugen eines Plasmas in den Vakuumbehälter einführen kann, und
eine Prozeßgas-Zufuhrvorrichtung (52, 53), die ein Prozeßgas zum Durchführen eines vorbestimmten Plasmaprozesses an dem Substrat in den Vakuumbehälter einführen kann,
wobei eine Öffnungsdichte der Gasöffnungen (33, 63) der Plasmaerzeugungsgas-Zufuhrvorrichtung (32, 62) in einem Bereich für einen Umfangsbereich des Substrats höher ist als in einem Bereich für einen Mittelbereich des Substrats, und wobei die Plasmaerzeugungsgas-Zufuhrvorrichtung (32, 62) und die Prozeßgas-Zufuhrvorrichtung (52, 53) separat angeordnet sind, **gekennzeichnet durch** ein Gasöffnungen-Blockierungselement (34, 64) zum Blockieren der Gasöffnungen (33, 63) der Plasmaerzeugungsgas-Zufuhrvorrichtung (32, 62), wobei das Gasöffnungen-Blockierungselement (34, 64) einstellbar ist, um die Gasöffnungen zu ändern, die **durch** dieses blockiert sind.

2. Gasverarbeitungseinheit nach Anspruch 1, bei der eine Öffnungsgröße einer jeden Gasöffnung (33) der Plasmaerzeugungsgas-Zufuhrvorrichtung (32) in dem Bereich für den Umfangsbereich des Substrats größer als eine Öffnungsgröße (33) einer jeden der Gasöffnungen der Plasmaerzeugungsgas-Zufuhrvorrichtung (32) in dem Bereich für den Mittelbereich des Substrats ist.

3. Gasverarbeitungseinheit nach Anspruch 1 oder 2, bei der eine Anzahl von Gasöffnungen (33) der Plasmaerzeugungsgas-Zufuhrvorrichtung (32) in dem Bereich für den Umfangsbereich des Substrats größer ist als in dem Bereich für den Mittelbereich des Substrats.

4. Gasverarbeitungseinheit nach einem der vorhergehenden Ansprüche, bei der das Gasöffnungen-Blockierungselement (34) geeignet ist, die Gasöffnungen (33) des Gaszufuhrelements in dem Bereich für den Umfangsbereich des Substrats zu blockieren.

5. Gasverarbeitungseinheit nach einem der vorhergehenden Ansprüche, bei der das Gasöffnungen-Blockierungselement (34) austauschbar ist.

6. Gasverarbeitungseinheit nach einem der vorhergehenden Ansprüche, bei der das Gasöffnungen-Blockierungselement (34) eine Mehrzahl von klingenartigen Elementen aufweist, die auf eine einstellbare Weise überlappen.

7. Gasverarbeitungseinheit nach Anspruch 1, die ferner folgendes umfaßt:
ein mikrowellendurchläßiges Fenster (23), welches hermetisch in einer Öffnung angeordnet ist, die in dem Vakuumbehälter (2) ausgebildet ist, wobei das Fenster (23) dem Substrat zugewandt ist,
einen Wellenleiter (25), der mit dem Vakuumbehälter (2) über das mikrowellendurchläßige Fenster (23) verbunden ist, um eine Mikrowelle in den Vakuumbehälter einzuführen, und
Magnetfeld-Ausbildungsmittel zum Erzeugen eines Magnetfeldes in dem Vakuumbehälter (2),
wobei die Gasverarbeitungseinheit geeignet ist, eine Elektronen-Zyklotron-Resonanz zwischen der Plasmaerzeugungsgas-Zufuhrvorrichtung (32) und der Prozeßgas-Zufuhrvorrichtung (52, 53) in dem Vakuumbehälter (2) durch eine Wechselwirkung der durch den Wellenleiter (25) zugeführten Mikrowelle und dem Magnetfeld zu erzeugen, um das Prozeßgas in ein Plasma zu wandeln und um das Substrat durch das Plama zu bearbeiten.

8. Gasverarbeitungseinheit nach Anspruch 7, bei der die Plasmaerzeugungsgas-Zufuhrvorrichtung (32) aus einem mikrowellendurchläßigen Material hergestellt ist.

9. Gasverarbeitungseinheit nach Anspruch 7 oder 8, bei der das Gasöffnungen-Blockierungselement (34) aus einem elektrischen Leiter besteht.

10. Gasverarbeitungseinheit nach einem der Ansprüche 7 bis 9, bei der die Gasöffnungen (33) der Plasmaerzeugungsgas-Zufuhrvornchtung (32) in einem Raum zwischen dem mikrowellendurchläßigen Fenster (23) und dem auf der Station (4) plazierten Substrat und in einer Ebene parallel zu dem Substrat angeordnet sind.

11. Gasverarbeitungseinheit nach einem der Ansprüche 7 bis 10, bei der die Plasmaerzeugungsgas-Zufuhrvorrichtung durch einen ringartigen hohlen Kasten (62) gebildet ist, der im wesentlichen in einem Umfangsbereich eines Raums zwischen dem mikrowellendurchläßigen Fenster (23) und dem auf der Station plazierten Substrat angeordnet ist und eine Mehrzahl von Gasöffnungen (63), die dem Substrat zugewandt sind, in einem Basisabschnitt hat.

12. Gasverarbeitungseinheit nach einem der vorhergehenden Ansprüche, bei der die Station (4) geeignet ist, ein im wesentlichen kreisförmiges Substrat zu halten, die Gasöffnungen (33) in einer Ebene parallel zu dem Substrat angeordnet sind, und der Vakuumbehälter (2) zumindest an einem Abschnitt, der mit den Gasöffnungen (33) versehen ist, eine im wesentlichen zylindrische Form hat.

13. Gasverarbeitungseinheit nach einem der vorhergehenden Ansprüche, die ferner einen Mechanismus für eine Ätzverarbeitung umfaßt.

14. Gasverarbeitungseinheit nach einem der vorhergehenden Ansprüche, die ferner einen Mechanismus zum Ausbilden eines Films umfaßt.

15. Gasverarbeitungseinheit nach einem der vorhergehenden Ansprüche, bei der die Plasmaerzeugungsgas-Zufuhrvorrichtung durch einen ringartigen hohlen Kasten (62) gebildet ist und eine Mehrzahl von Gasöffnungen (63), die dem Substrat zugewandt sind, in einem Basisabschnitt desselben aufweist.

## Revendications

1. Unité de traitement au gaz comprenant :
• un étage (4) sur lequel un substrat (w) peut être placé,
• un récipient sous vide (2) entourant l'étage, à l'intérieur duquel on peut faire un vide,
• un dispositif d'alimentation en gaz générant du plasma (32) comportant une pluralité de trous pour le gaz (33, 63), qui peut introduire un gaz destiné à générer du plasma dans le récipient sous vide, et
• un dispositif d'alimentation en gaz de traitement (52, 53) qui peut introduire un gaz de traitement destiné à réaliser un procédé au plasma prédéterminé sur le substrat dans le récipient sous vide,
dans laquelle une densité d'ouverture des trous pour le gaz (33, 63) du dispositif d'alimentation en gaz générant du plasma (32, 62) est plus grande dans une zone pour une surface périphérique du substrat que dans une zone pour une surface centrale du substrat, et le dispositif d'alimentation en gaz générant du plasma (32, 62) et le dispositif d'alimentation en gaz de traitement (52, 53) sont disposés séparément ; **caractérisée par** un élément d'obstruction des trous pour le gaz (34, 64) destiné à obstruer les trous pour le gaz (33, 63) du dispositif d'alimentation en gaz générant du plasma (32, 62), l'élément d'obstruction des trous pour le gaz (34, 64) étant réglable pour changer les trous pour le gaz obstrués par celui-ci.

2. Unité de traitement au gaz selon la revendication 1, dans laquelle :
• une taille d'ouverture de chacun des trous pour le gaz (33) du dispositif d'alimentation en gaz générant du plasma (32) dans la zone pour surface périphérique du substrat est plus grande qu'une taille d'ouverture (33) de chacun des trous pour le gaz du dispositif d'alimentation en gaz générant du plasma (32) dans la zone pour la surface centrale du substrat.

3. Unité de traitement au gaz selon la revendication 1 ou 2, dans laquelle :
• un certain nombre des trous pour le gaz (33) du dispositif d'alimentation en gaz générant du plasma (32) est plus grand dans la zone pour la surface périphérique du substrat que dans la zone pour la surface centrale du substrat.

4. Unité de traitement au gaz selon l'une des revendications précédentes, dans laquelle :
• l'élément d'obstruction des trous pour le gaz (34) est adapté pour obstruer les trous pour le gaz (33) du dispositif d'alimentation en gaz dans la zone pour la surface périphérique du substrat.

5. Unité de traitement au gaz selon l'une des revendications précédentes, dans laquelle :
• l'élément d'obstruction des trous pour le gaz (34) est échangeable.

6. Unité de traitement au gaz selon l'une des revendications précédentes, dans laquelle :
• l'élément d'obstruction des trous pour le gaz (34) présente une pluralité d'éléments en forme de lames se chevauchant d'une manière réglable.

7. Unité de traitement au gaz selon la revendication 1, comprenant en outre :
• une fenêtre laissant pénétrer les micro-ondes (23) disposée de manière hermétique dans une ouverture formée dans le récipient sous vide (2), la fenêtre (23) faisant face au substrat,
• un guide d'onde (25) raccordé au récipient sous vide (2) par l'intermédiaire de la fenêtre faisant pénétrer les micro-ondes (23) pour introduire une micro-onde dans le récipient sous vide (2), et
• un moyen de formation de champ magnétique destiné à générer un champ magnétique dans le récipient sous vide (2),
• l'unité de traitement au gaz étant adaptée pour générer une résonance cyclotronique des électrons entre le dispositif d'alimentation en gaz générant du plasma (32) et le dispositif d'alimentation en gaz de traitement (52, 53) dans le récipient sous vide (2) par une interaction de la micro-onde introduite par l'intermédiaire du guide d'onde (25) et du champ magnétique, afin de changer le gaz de traitement en plasma et de traiter le substrat par le plasma.

8. Unité de traitement au gaz selon la revendication 7, dans laquelle :
• le dispositif d'alimentation en gaz générant du plasma (32) est fait d'un matériau laissant pénétrer les micro-ondes.

9. Unité de traitement au gaz selon la revendication 7 ou 8, dans laquelle :
• l'élément d'obstruction des trous pour le gaz (34) est fait d'un conducteur électrique.

10. Unité de traitement au gaz selon l'une des revendications 7 à 9, dans laquelle :
• les trous pour le gaz (33) du dispositif d'alimentation en gaz générant du plasma (32) sont disposés dans un espace compris entre la fenêtre laissant pénétrer les micro-ondes (23) et le substrat placé sur l'étage (4) et dans un plan parallèle au substrat.

11. Unité de traitement au gaz selon l'une des revendications 7 à 10, dans laquelle :
• le dispositif d'alimentation en gaz générant du plasma est formé par une boîte creuse de type anneau (62) disposée dans une zone sensiblement périphérique d'un espace compris entre la fenêtre laissant pénétrer les micro-ondes (25) et le substrat placé sur l'étage, dont la pluralité de trous pour le gaz (63) fait face au substrat dans une partie de base de celui-ci.

12. Unité de traitement au gaz selon l'une des revendications précédentes, dans laquelle :
• l'étage (4) est adapté pour soutenir un substrat sensiblement circulaire,
• les trous pour le gaz (33) sont disposés dans un plan parallèle au substrat, et
• le récipient sous vide (2) présente une forme sensiblement cylindrique au moins au niveau d'une partie munie des trous pour le gaz (33).

13. Unité de traitement gaz selon l'une des revendications précédentes, comprenant en outre :
• un mécanisme de traitement par attaque chimique.

14. Unité de traitement au gaz selon l'une des revendications précédentes, comprenant en outre :
• un mécanisme de traitement filmogène.

15. Unité de traitement au gaz selon l'une des revendications précédentes, dans laquelle :
• le dispositif d'alimentation en gaz générant du plasma est formé par une boîte creuse de type anneau (62), dont la pluralité de trous pour le gaz (63) fait face au substrat dans une partie de base de celui-ci.
